# EUROPEAN PATENT SPECIFICATION

(11) **EP 4 657 034 B1**
(45) Date of publication and mention of the grant of the patent: **19.08.2026**
(21) Application number: 24178278.8
(22) Date of filing: 27.05.2024
(51) Int. Cl.: G01J 3/10

(54) **DEVICE FOR EMISSION OF THERMAL RADIATION AND METHOD OF OPERATING**
VORRICHTUNG ZUR EMISSION VON WÄRMESTRAHLUNG UND VERFAHREN ZUM BETRIEB
DISPOSITIF D'ÉMISSION DE RAYONNEMENT THERMIQUE ET PROCÉDÉ DE FONCTIONNEMENT

(43) Date of publication of application: 03.12.2025
(60) Divisional application: 26161800.3 / 4 752 509
(73) Proprietor: Axetris AG, 6056 Kägiswil (CH)
(72) Inventor: LOSIO, Paolo Antonio, 6056 Kägiswil (CH); ULRICH, Roger, 6056 Kägiswil (CH); INTLEKOFER, Alexander, 6012 Obernau (CH)
(74) Representative: Witte, Weller & Partner Patentanwälte mbB

(56) References cited:
- WO-A1-2020/144365
- US-B2- 11 490 460
- US-B2- 9 995 700

## Description

The present invention relates to a device for emission of thermal radiation and method of operating such device. Such a device may also be referred to as a thermal emitter or as an infrared source.

Thermal emitters are a key component in gas analysis, utilizing Micro-Electro-Mechanical Systems (MEMS) technology to efficiently emit thermal radiation similar to that of a black body. A black body is an idealized physical body that absorbs all incident electromagnetic radiation, making it an excellent reference for thermal emission. MEMS-based thermal emitters typically consist of microscale structures that can be heated to high temperatures, causing them to emit infrared radiation. These devices are precisely designed to achieve desired spectral characteristics, enabling accurate and selective gas analysis based on the unique absorption and emission spectra of different gases.

A key advantage of MEMS-based thermal emitters is their compact size, quick electrical modulation and low power consumption. The integration of MEMS technology allows the creation of miniaturized and energy efficient thermal emitters, making them well suited for portable and field deployable gas analysis systems. Precise control of the emission spectra also enhances the selectivity and sensitivity of these devices, allowing specific gases to be detected and analyzed with high accuracy.

Thermal emitters have a wide range of applications in gas analysis across a variety of industries. One notable application is in environmental monitoring, where they are used to detect and quantify airborne pollutants. In addition, thermal transmitters are valuable in industrial processes such as combustion control and emission monitoring. They play a vital role in ensuring the efficiency and compliance of manufacturing processes by providing real-time data on gas composition. In medical applications, thermal emitters are used for breath analysis, enabling non-invasive diagnostics through the detection of specific biomarkers. The versatility, compactness and precision of MEMS-based thermal emitters make them indispensable in advancing gas analysis technologies for a wide range of applications.

In addition, the scalability and versatility of MEMS-based thermal emitters contribute to their widespread adoption in various gas sensing platforms. These emitters can be integrated into sensor arrays, enabling the simultaneous detection of multiple gases in complex environments. For example, in healthcare, MEMS-based thermal emitters have applications beyond breath analysis. They are used in medical devices to detect trace gases associated with metabolic processes and diseases.

As technology continues to advance, MEMS-based thermal emitters will play a key role in the development of next-generation gas sensing technologies. Continued refinement of the manufacturing processes and materials used in MEMS devices is expected to further improve the performance and reliability of thermal emitters. This in turn will contribute to the further development of gas analysis techniques, with implications for environmental monitoring, industrial processes, healthcare diagnostics and beyond. The intersection of MEMS technology and thermal emitters represents a promising frontier in the quest for more efficient, portable and accurate gas sensing solutions.

The thermal emitters or infrared (IR) sources described here are micromachined, electrically modulated thermal infrared emitters featuring true black body radiation characteristics, quick electrical modulation, low power consumption, high emissivity, and a long lifetime. The appropriate design is based on a resistive heating element deposited onto a thin dielectric membrane which is suspended on a micromachined silicon structure.

US 9,995,700 B2 states that a sensor device comprises a hotplate on a membrane. The hotplate is heated by a N-fold rotationally symmetric heater structure having N>1 heater elements of identical design. Each heater element comprises an inner section, an intermediate section and an outer section arranged in series, with the inner section having a larger electrical cross section than the outer section. This design allows to heat the hotplate to a homogeneous temperature at moderate supply voltages.

WO 2020/144365 A1 relates to an infrared light source for gas sensor, including a membrane connected to a substrate by at least two joining arms, the light source including a conductive track running between two connection pads, which are arranged on the substrate, along at least two joining arms, and through the membrane, the conductive track being configured to cause the membrane to heat up when an electric current flows therethrough; the membrane including a support layer formed of at least one dielectric material and a distributing layer, which is thermally conductive and configured to spatially distribute the heating of the membrane; the membrane having a diameter or being inscribed within a diameter smaller than 1 mm; and the conductive track forming, between the connection pads, at least two conductive branches and at most four conductive branches arranged in parallel, each branch forming an electrical resistor.

US 11,490,460 B2 states that an emitter structure includes a substrate with a membrane arrangement. The membrane arrangement includes at least one first membrane, a first heating path and a second heating path in different substrate planes. The first heating path and the second heating path are positioned with respect to one another such that a projection of the first heating path and a projection of the second heating path onto a common plane lie at least partly next to one another in the common plane.

It is an object of the present invention to provide an improved device for emission of thermal radiation, an improved system for emission of thermal radiation and an improved method of operating a device for emission of thermal radiation.

According to a first aspect, there is provided a method of operating a device according to claim 1.

The dependency on the radiated optical power depends on the fourth power of the temperature (P *= εσAT*⁴). The proposed method ensures that in order to achieve a certain power output, it is preferred to increase the voltage and thus the temperature of exactly one resistive element rather than increasing the voltages for both resistive elements. The emitter is most efficient when operated at its maximal operation temperature, as the dependance of the required input power on temperature is of a lower order (E = P_{optical} / P_{electrical}). It should be noted that there is also a dependency on the total surface area at a certain temperature. Maximum temperature is limited by material properties and for a given material system there are limits difficult to overcome, especially with microstructures. Additionally, the emitted spectrum is dependent on the surface temperature (Planck Blackbody law). The total surface area is limited by geometric constraints, but in principle it is easier to increase the emitting surface. Therefore, controlling the emitting surface area roughly independently of the temperature allows for more optimization possibilities.

If the resistive first element reaches its maximum temperature while the desired optical output power is not reached yet, the method activates additionally the resistive second element which can provide more power than the resistive first element alone. As the resistive second element takes over, i.e. the second voltage increases, the voltage of the resistive first element is reduced towards the target low first voltage. In some improvements, the resistive first element lies within an inner section of the resistive second element. This position allows for a good heat transfer to the emitter. It also supports the design of making the second element larger than the first element so that it can provide more power than the first element.

The maximum optical output power is limited by a predefined maximum temperature that neither the first element nor the second element should exceed. The maximum temperature is achieved when the first element receives the target low first voltage and the second element receives the second maximum voltage. The possibility to set the desired optical output power can be limited to not exceed the maximum optical output power. Or, if it is allowed to set a higher desired optical output power, the actual optical output power will still be maintained at the maximum optical output power.

According to an improvement, the second predefined threshold is defined by a predefined maximum temperature of the first and second elements that is achieved when the target low first voltage is applied to the first contact sections and the second maximum voltage is applied to the second contact sections.

According to a second aspect, there is provided a device for emission of thermal radiation according to claim 2.

Having the first and second contact sections on two different sides of the structure has the advantage of an improved thermal distribution. Also, the design of the structure can be made compact. There is also more room available to connect the structure to one or more power supplies. The device is preferably manufactured using the technology of Micro-Electro-Mechanical Systems (MEMS).

As will be seen from preferred embodiments, it is preferred that the elements of the structure do not overlap when looking onto the plane. Also, the design offers flexibility as to how the resistive elements are used. As will become clear when reviewing the preferred embodiments, one or more elements can be used as a heating element or heater with an optional element to measure the temperature of the structure. It is preferred that each resistive element is monolith, i.e. provided as one single piece made from a single material.

In some embodiments, the contact sections can be identified as follows. The resistive structure is assigned a footprint which can be determined by virtually extending a periphery of the outermost resistive element, in particular of the second element, into a closed shape primitive, e.g. a circle, an oval, a rectangle or a regular polygon like a triangle, square, pentagon, hexagon, heptagon, octagon, etc. The contact sections can be understood as those sections of the respective resistive elements that extend beyond the closed shape primitive.

According to an improvement, the first side and the second side are at an angle of greater than 45° and less than 315° to each other relative to a center of the structure.

This allows for a good separation of the corresponding contact sections. The angle lies in particular in the range of 60° to 300°, preferably in the range of 90° to 270°, more preferably in the range of 120° to 240°, and especially in the range of 150° to 210°.

According to a further improvement, the at least one of the first contact sections and the at least one of the second contact sections are at an angle of greater than 45° and less than 315° to each other relative to a center of the structure.

This allows for a good separation of the corresponding contact sections. The angle lies in particular in the range of 60° to 300°, preferably in the range of 90° to 270°, more preferably in the range of 120° to 240°, and especially in the range of 150° to 210°. In particular, all of the first contact sections in relation to all of the second contact sections are at such angle to each other to a center of the structure.

According to a further improvement, the at least one of the first contact sections and the at least one of the second contact sections are arranged in opposition to each other across a center of the structure.

This allows for a good separation of the corresponding contact sections.

According to a further improvement, in the plane, a second outer periphery of the second element has an opening adapted to provide a passage for the first element from the electrical first contact sections arranged outside the second outer periphery to a second inner portion of the second element.

This allows for a more compact design.

According to a further improvement, in the plane, a second inner periphery of the second element is facing a first outer periphery of the first element.

This allows for a good use of the area available for the structure.

According to a further improvement, over a major portion of the first outer periphery, the first outer periphery has a gap of a constant width towards the second inner periphery.

This allows for a good use of the area available for the structure.

According to a further improvement, the second element has a horseshoe-like shape with an opening and the first element passes through the opening.

This allows for a more compact design. The horseshoe-like shape can be rounded, can be a polygon, i.e. a combination of a plurality of lines, or can be a combination of rounded elements and lines. The horseshoe-like shape has an opening between two arms of the shape, the opening leading into an interior of the shape. Entering the interior from the opening, the interior widens to a maximum width. Continuing on, the interior becomes smaller and smaller until the two arms meet.

According to a further improvement, in the plane, a first surface of the first element is less than a second surface of the second element.

This may allow to obtain different heating characteristics of the resistive elements.

According to a further improvement, the second element comprises a second conductive track extending from the electrical second contact sections, and wherein the second conductive track comprises a second inner section and a second outer section.

This improvement makes effective use of the area available for the structure.

According to a further improvement, the second inner section has a shape of an arc with an arc angle between 270° and 345° and/or wherein the second outer section comprises two further arcs, each further arc with a further arc angle between 105° and 175°.

This improvement makes effective use of the area available for the structure. The arc angle and the further arc angle can be determined with reference to the center of the structure.

According to a further improvement, the structure further comprises a resistive third element that is arranged in the plane and within a first inner periphery of the first element.

This improvement allows for an additional functionality.

According to a further improvement, the structure further comprises a resistive auxiliary element adapted to be used for measuring a temperature of the structure and/or of the substrate.

This improvement allows for a compact integration of a temperature measuring element. In order to differentiate between elements for heating and elements, the following is noted regarding resistances measured when the temperature of the element is at room temperature. A resistive element for heating will preferably have a resistance below 100Ω, and a resistive element for heating will preferably have a resistance above 100Ω. More preferably, a resistive element for heating will have a resistance below 80Ω, and a resistive element for heating will have a resistance above 200Ω. In particular, a resistive element for heating will have a resistance below 70Ω, and a resistive element for heating will have a resistance above 300Ω. In general, temperature sensing is achieved by using a material where the resistance depends on temperature, especially where the resistance increases with increasing temperature, typically a metal.

The resistive auxiliary element may be positioned on the frame, i.e. the substrate that is shaped like a frame for the membrane. The resistive auxiliary element will measure the temperature of the frame, i.e. of the substrate, which has a significantly lower temperature than the maximum temperature of the structure. However, the temperature of the substrate is still related to the temperature of the structure. The effect is that thermal cycling of the sensing element is reduced, therefore the properties of the resistive auxiliary element will be more stable and the measurement more reliable over the device lifetime of several years. The corresponding control algorithm for controlling the temperature of the structure will consider that the temperature is not directly measured. The control algorithm may also take into account the ambient temperature as this influences the temperature of the structure as well. Another approach that will be explained is to measure at temperature at the center of the structure. Thereby, the heater temperature, i.e. the temperature of the structure, is measured directly.

According to a third aspect, there is provided a system for optical gas analysis according to claim 15.

Embodiments of the invention are shown in the drawings and are explained in more detail in the following description. In the drawings:
Fig. 1 shows an embodiment of a system for optical gas analysis.
Fig. 2 shows a cross-section of the general structure of device for emission of thermal radiation.
Fig. 3 shows a first embodiment of a device for emission of thermal radiation.
Fig. 4 shows a second embodiment of a device for emission of thermal radiation.
Fig. 5 shows a third embodiment of a device for emission of thermal radiation.
Fig. 6 shows a fourth embodiment of a device for emission of thermal radiation.
Fig. 7 shows a fifth embodiment of a device for emission of thermal radiation.
Fig. 8 shows a sixth embodiment of a device for emission of thermal radiation.
Fig. 9 shows a seventh embodiment of a device for emission of thermal radiation.
Fig. 10 shows an eighth embodiment of a device for emission of thermal radiation.
Fig. 11 shows a ninth embodiment of a device for emission of thermal radiation.
Fig. 12 shows a tenth embodiment of a device for emission of thermal radiation.
Fig. 13 shows an eleventh embodiment of a device for emission of thermal radiation.
Fig. 14 shows a twelfth embodiment of a device for emission of thermal radiation.
Fig. 15 shows a thirteenth embodiment of a device for emission of thermal radiation.
Fig. 16 shows a fourteenth embodiment of a device for emission of thermal radiation.
Fig. 17 shows a fifteenth embodiment of a device for emission of thermal radiation.
Fig. 18 shows an embodiment of a method of operating a device with a resistive first element and a resistive second element.

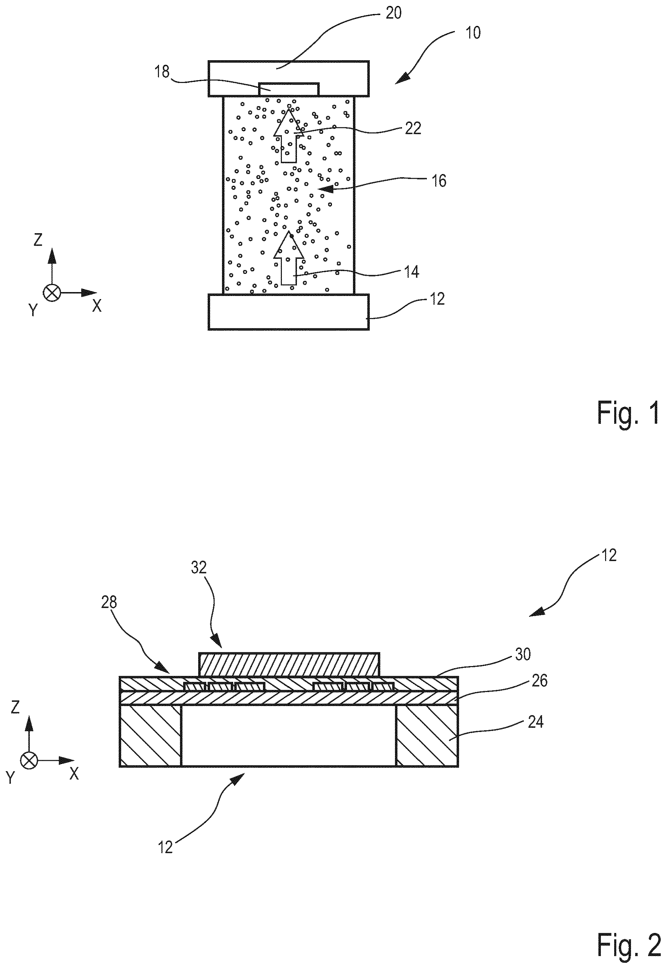

Fig. 1 shows an embodiment of a system 10 for optical gas analysis. The system 10 comprises a device 12 for emission of thermal radiation in the form of a first light 14, here a light in the infrared range. The device 12 emits the first light 14 through a gas 16, symbolized as small dots, to be analyzed.

The system 10 further comprises at least one light sensor 18 and an analyzer 20. The analyzer 20 determines at least one gas concentration of at least one component of the gas 16 based on a second light 22 detected by the at least one light sensor 18.

The relationship of the first light 14 and the second light 22 is that the first light 14 changes into the second light 22 when passing through the gas. This change occurs because certain wavelengths contained in the first light are attenuated by the gas, thus resulting in the second light. As different gases attenuate the first light in different ways, the second light gives an indication regarding the type of gas and its concentration.

Fig. 2 shows a cross-section of the general arrangement of a device 12 for emission of thermal radiation, especially infrared light. The device 12 comprises a substrate 24 and a membrane 26, wherein the substrate 24 provides a frame for the membrane 26. It can be seen that the substrate 24 has a cavity which exposes an area of an underside of the membrane 26. The cavity in the substrate 24 is typically created by etching, so that the substrate 24 obtains a frame-like shape.

A resistive structure 28 is arranged on the membrane 26. The resistive structure 28 is embedded in an optional passivation layer 30. The structure 26 is arranged at least substantially within a plane. In this representation, the plane is perpendicular to the drawing layer, i.e.it extends towards the viewer of the drawing. In the given orientation the plane is the XY-plane.

An emitter 32 of the thermal radiation is arranged over the structure 28. The resistive structure 28 is heated by running a current through the structure. The heat from the structure 28 is received by the emitter 32 and is then emitted. The emitter 32 is configured to provide desired emission characteristics.

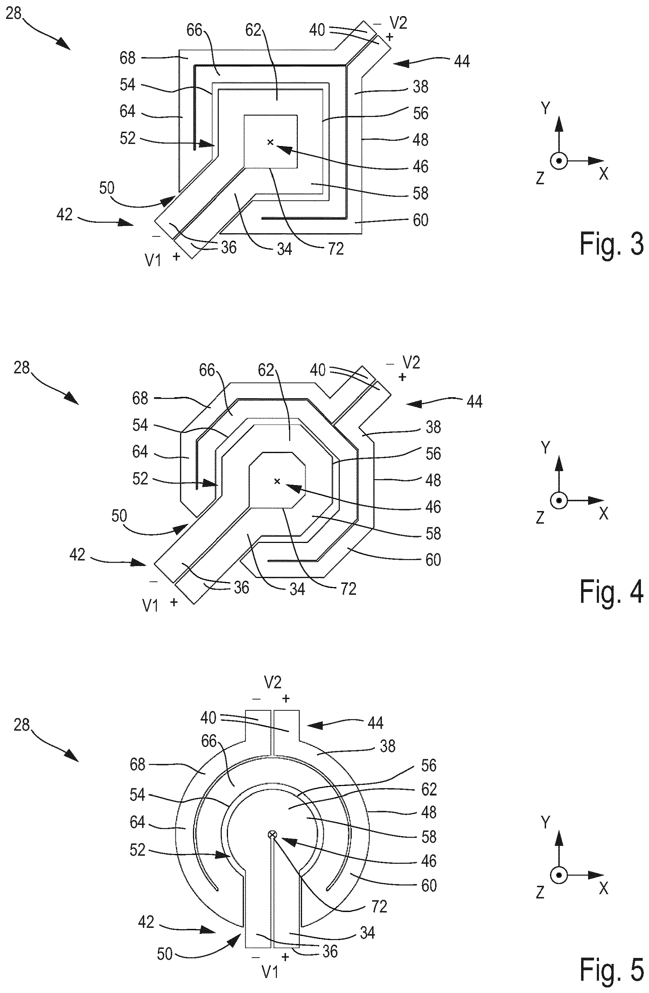

Fig. 3 shows a first embodiment of a device for emission of thermal radiation. With the exception of the structure 28, the elements of the general arrangement are not shown in order to not obscure the invention. Rather, the resistive structure 28 is being focused on. This also applies to all other embodiments of the device 12.

The resistive structure 28 comprises a resistive first element 34 with electrical first contact sections 36 and a resistive second element 38 with electrical second contact sections 40. The first contact sections 36 are provided with a variable first voltage V1, and the second contact sections 40 are provided with a second voltage V2. The first and second voltages V1, V2 are chosen to obtain a desired heating of the resistive first and/or second elements 34, 38 which causes the emitter 32 to emit a desired optical output power. The negative potentials of first and second voltages V1, V2 can be 0V or GND. The first and second voltages V1, V2 can be variable between two states, e.g. 0V and 5V, can have a plurality of discrete steps, e.g. 0V, 1V, 2V, 3V, or can be continuously variable, e.g. between 0V and 7V.

At least one of the first contact sections 36, here, both contact sections 36 are arranged on a first side 42 of the structure 28 and at least one of the second contact sections 40, here, both contact sections 40 are arranged on a second side 44 of the structure 28 and wherein the first side 42 is different from the second side 44.

The first element 34 up to and including the first contact sections 36 is formed separately from the second element 38 up to and including the second contact sections 40. This means that the first element 34 and the second element 38 are separated by a gap up to and including their respective contact sections 36, 40.

In order to heat the structure 28, one or more currents are run through at least one of the first element 34 or the second element 38. Depending on the configuration of the first and second elements 34, 38 and the value of the one or more currents, the structure 28 is heated to a desired level, so that the emitter 32 can emit a desired power, more specifically, a desired optical output power.

The first side 42 and the second side 44 are at an angle of greater than 45° and less than 315° to each other relative to a center 46 of the structure. Here, the angle is at least approximately 180°.

Further, the at least one first contact section 36 and the at least one second contact section 40 are at an angle of greater than 45° and less than 315° to each other relative to the center 46 of the structure 28. Here, the angle is at least approximately 180°. Also, both first contact sections 36 are at an angle of at least approximately 180° to both second contact sections 40 relative to the center 46 of the structure 28.

In this embodiment, the at least one of the first contact sections 36 and the at least one of the second contact sections 40 are arranged in opposition to each other across the center 46 of the structure 28. Here, both first contact sections 36 are arranged in opposition to both second contact sections 40 across the center 46 of the structure 28.

In the plane in which the structure 28 is arranged, i.e. the XY-plane, a second outer periphery 48 of the second element 38 has an opening 50 adapted to provide a passage for the first element 34 from the electrical first contact sections 36 arranged outside the second outer periphery 48 to a second inner portion 52 of the second element 38.

In the plane XY, a second inner periphery 54 of the second element 38 is facing a first outer periphery 56 of the first element 34. Also, at least over a major portion of the first outer periphery 56, the first outer periphery 56 has a gap of a constant width towards the second inner periphery 54. It is noted that the first element 34 also has a first inner periphery 72.

The second element 38 has a horseshoe-like shape with the opening 50 and the first element 34 passes through the opening 50. In the plane XY, a first surface 58 of the first element 34 is less than a second surface 60 of the second element 38.

The first element 34 comprises a first conductive track 62 extending from the electrical first contact sections 36. The second element 38 comprises a second conductive track 64 extending from the electrical second contact sections 40, and wherein the second conductive track 64 comprises a second inner section 66 and a second outer section 68. At least a major portion of the second inner section 66 runs at least substantially parallel to the second outer section 68. A width of the second inner section 66 is wider than a further width of the second outer section 68.

The general shape of the footprint of the resistive structure 28 is a rectangle, here in particular a square. The general shape of the footprint can be determined by virtually extending the second outer periphery 48 into a closed shape primitive.

Fig. 4 shows a second embodiment of a device for emission of thermal radiation. All the explanations made in the context of the first embodiment apply as well and will not be repeated. Also, all reference numerals introduced in the context of the first embodiment continue to apply as well and will only be repeated selectively. The general shape of the footprint of the resistive structure 28 is an octagon.

Fig. 5 shows a third embodiment of a device for emission of thermal radiation. All the explanations made in the context of the first embodiment apply as well and will not be repeated. Also, all reference numerals introduced in the context of the previous embodiments continue to apply as well and will only be repeated selectively. The general shape of the footprint of the resistive structure 28 is an oval, here in particular a circle.

The second inner section has a shape of an arc with an arc angle between approximately 270° and 345° and/or wherein the second outer section comprises two further arcs, each further arc with a further arc angle between approximately 105° and 175°. Here, first arc angle is approximately 325°, and the further arc angle is approximately 150°.

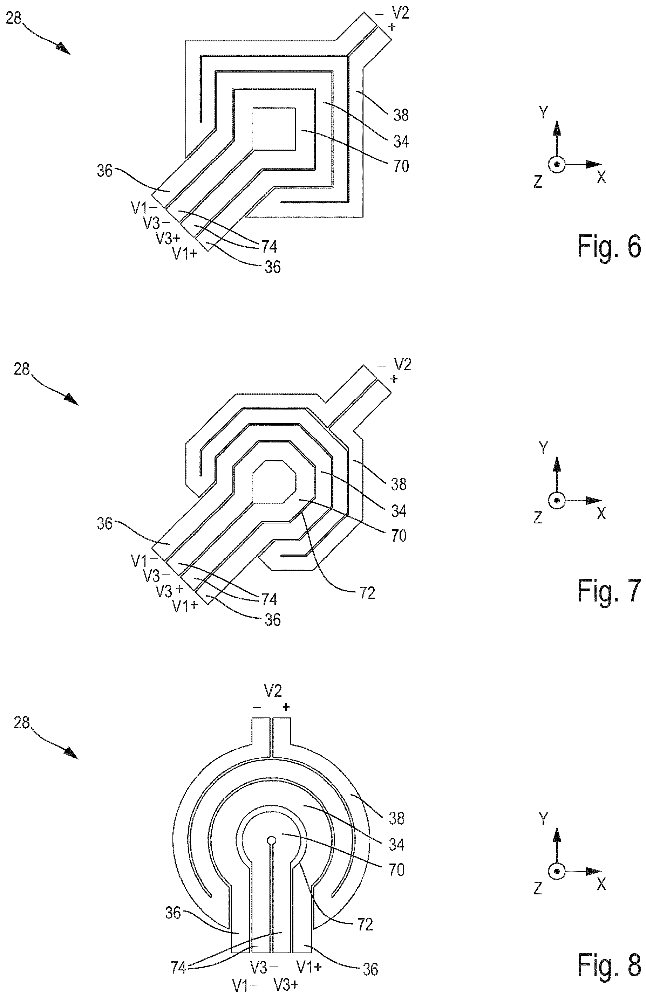

Fig. 6 shows a fourth embodiment of a device for emission of thermal radiation. All the explanations made in the context of the first embodiment apply as well and will not be repeated. Also, all reference numerals introduced in the context of the previous embodiments continue to apply as well and will only be repeated selectively.

In addition to the features of the first embodiment, the resistive structure 28 of the fourth embodiment comprises a resistive third element 70 arranged in the plane XY and within a first inner periphery 72 of the first element 34. The shape of the resistive third element 70 follows the shape of the resistive first element 34. For a majority of its longitudinal extension the resistive third element 70 is separated from the resistive first element 34 by an at least substantially constant gap.

The resistive first element 34 has electrical third contact sections 74 which are provided with a variable third voltage V3. Like the first and second voltages V1, V2 the third voltage V3 is chosen to obtain a desired heating of the resistive third element 70 which causes, either alone or in combination with at least one of the first and/or second elements 34, 38, the emitter 32 to emit a desired optical output power. The negative potential of the third voltage V3 can be 0V or GND. The third voltage V3 can be variable between two states, can have a plurality of discrete steps, or can be continuously variable.

The first element 34 up to and including the first contact sections 36 is formed separately from the third element 70 up to and including the third contact sections 74. This means that the first element 34 and the third element 70 are separated by a gap up to and including their respective contact sections 36, 74.

Fig. 7 shows a fifth embodiment of a device for emission of thermal radiation. All the explanations made in the context of the second and fourth embodiments apply as well and will not be repeated. Also, all reference numerals introduced in the context of the previous embodiments continue to apply as well and will only be repeated selectively.

Fig. 8 shows a sixth embodiment of a device for emission of thermal radiation. All the explanations made in the context of the third and fourth embodiments apply as well and will not be repeated. Also, all reference numerals introduced in the context of the previous embodiments continue to apply as well and will only be repeated selectively.

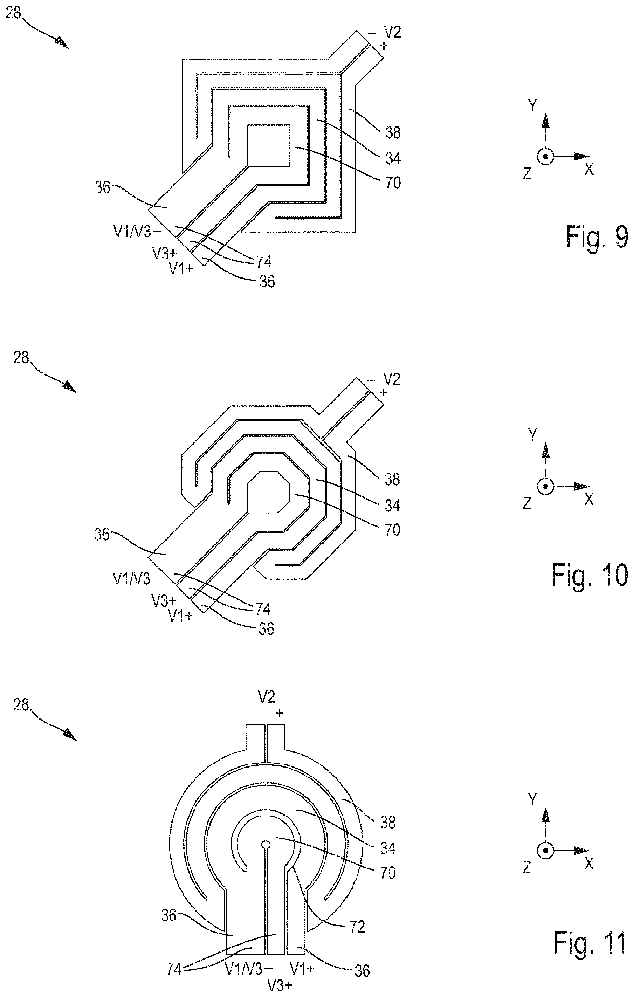

Fig. 9 shows a seventh embodiment of a device for emission of thermal radiation. All the explanations made in the context of the fourth embodiment apply as well and will not be repeated. Also, all reference numerals introduced in the context of the previous embodiments continue to apply as well and will only be repeated selectively.

Different from the fourth embodiment is that one of the electrical first contact sections 36 and one of the electrical third contact sections 74 that are, as seen in the fourth embodiment, adjacent to each other are combined. In particular, the resistive first and third elements 34, 70 can be formed as one monolithic element from one single material.

The current paths through the first and third elements 34, 70 are kept separate by a gap when starting from V1+ and V3+, and the gap only ends towards the first and third contact sections 36, 74. The gap may end within the footprint of the structure 28, as shown in this figure, but may also extend outside the footprint. The common potential V1/V3- can be 0V or GND, the latter indicating a common ground for the first and third elements 34, 70.

Fig. 10 shows an eighth embodiment of a device for emission of thermal radiation. All the explanations made in the context of the fifth and seventh embodiments apply as well and will not be repeated. Also, all reference numerals introduced in the context of the previous embodiments continue to apply as well and will only be repeated selectively. Here, the footprint of the structure 28 is in an octagon shape.

Fig. 11 shows a ninth embodiment of a device for emission of thermal radiation. All the explanations made in the context of the sixth and seventh embodiments apply as well and will not be repeated. Also, all reference numerals introduced in the context of the previous embodiments continue to apply as well and will only be repeated selectively. Here, the footprint of the structure 28 is in a circular shape.

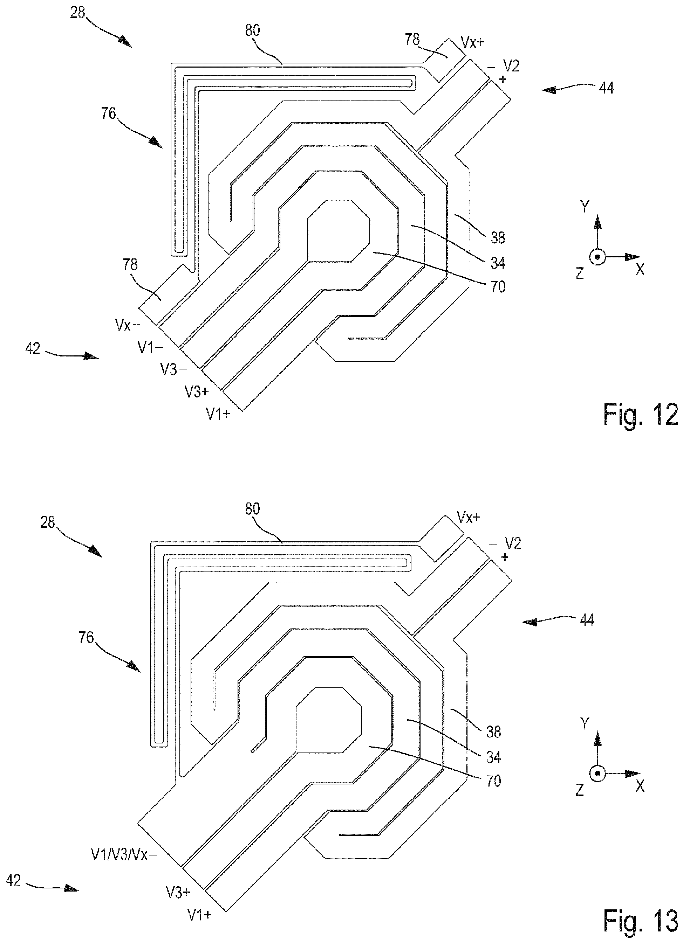

Fig. 12 shows a tenth embodiment of a device for emission of thermal radiation. All the explanations made in the context of the fifth embodiment apply as well and will not be repeated. Also, all reference numerals introduced in the context of the previous embodiments continue to apply as well and will only be repeated selectively.

In addition to the features of the fifth embodiment, the structure 28 further comprises a resistive auxiliary element 76 adapted to be used for measuring a temperature of the structure 28. The auxiliary element 76 has auxiliary contact sections 78 with one auxiliary contact section 78 arranged at the first side 42 and one auxiliary contact section 78 arranged at the second side 44. Further, the auxiliary element 76 has a sensing conductor 80 that connects the contact sections 78. By applying a sensing current to the auxiliary contact sections 78 and measuring the resulting voltage, the temperature of the structure 28 can be determined.

The auxiliary element 76 is closely arranged at the footprint of the structure 28. This arrangement allows for a good measurement of the structure's 28 temperature. Also, the auxiliary element 76 has longitudinal extensions along the X-axis and has longitudinal extensions along the Y-axis which leads to an overall rectangular shape of the structure 28.

The sensing element, i.e. the resistive auxiliary element 76, is arranged on the frame-shaped substrate 24 and will be at the same temperature as the substrate 24. The temperature of the substrate 24 will be significantly lower than the heater/emitter temperature, i.e. the temperature of the structure 28. For example, the temperature of the substrate 24 may be 80-100°C, when the heater is at 500°C and the ambient temperature is at 20-22°C. But, again, the temperature of the substrate depends on the heater/emitter temperature (and on the ambient temperature), so that the temperature of the substrate 24 can be used as an input control parameter as well.

This allows to control in average the heater temperature, but not so much the instantaneous temperature. This can be advantageous considering that the ambient temperature usually varies slowly and the heater temperature is determined by input energy (which is controlled) and ambient temperature (variable). Additionally the considerations on long-term stability mentioned above apply as well.

Fig. 13 shows an eleventh embodiment of a device for emission of thermal radiation. All the explanations made in the context of the eighth and tenth embodiments apply as well and will not be repeated. Also, all reference numerals introduced in the context of the previous embodiments continue to apply as well and will only be repeated selectively.

Like the eighth embodiment, one of the electrical first contact sections 36 and one of the electrical third contact sections 74 that are adjacent to each other are combined. In addition one of the auxiliary contact sections 78 is connected to these sections 36, 74. In particular, the resistive first and third elements 34, 70 and the auxiliary element 76 can be formed as one monolithic element from one single material.

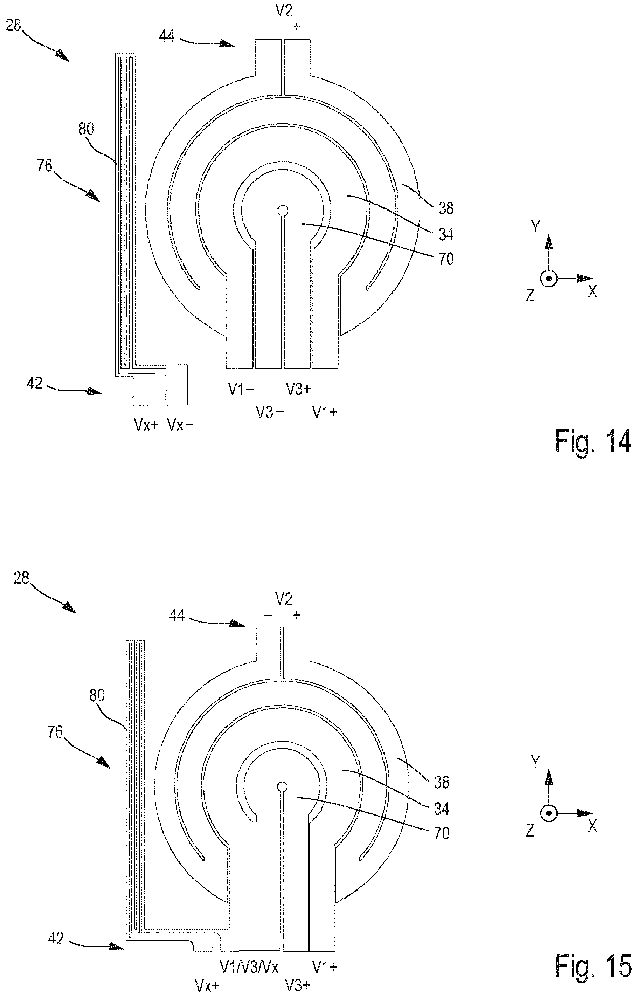

Fig. 14 shows a twelfth embodiment of a device for emission of thermal radiation. All the explanations made in the context of the sixth and tenth embodiment apply as well and will not be repeated. Also, all reference numerals introduced in the context of the previous embodiments continue to apply as well and will only be repeated selectively. Here, the footprint of the structure 28 is in a circular shape.

Fig. 15 shows a thirteenth embodiment of a device for emission of thermal radiation. All the explanations made in the context of the ninth and twelfth embodiment apply as well and will not be repeated. Also, all reference numerals introduced in the context of the previous embodiments continue to apply as well and will only be repeated selectively.

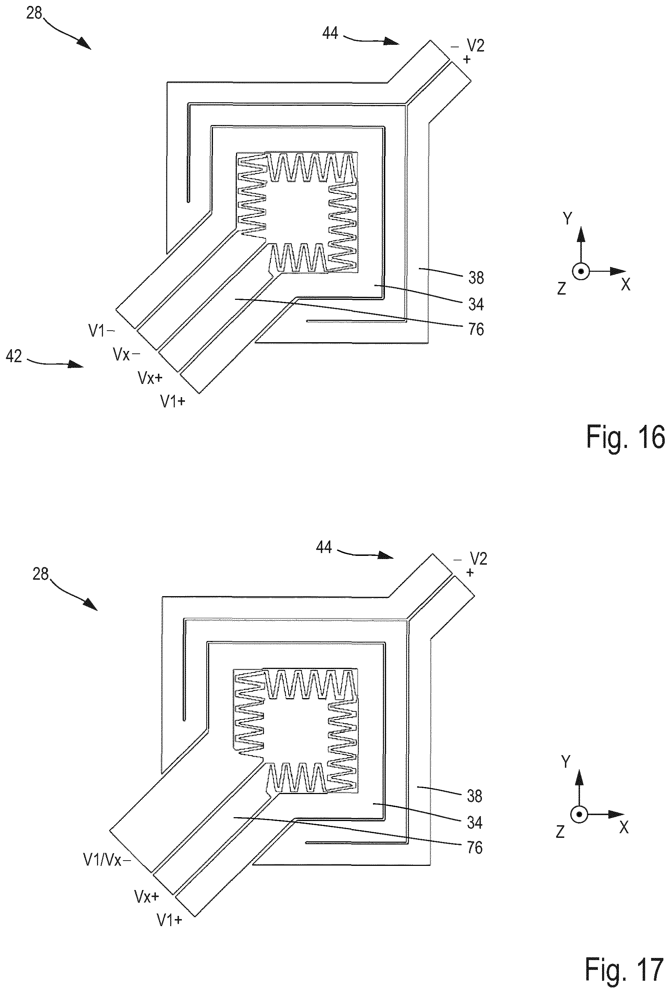

Fig. 16 shows a fourteenth embodiment of a device for emission of thermal radiation. All the explanations made in the context of the fourth embodiments apply as well and will not be repeated. Also, all reference numerals introduced in the context of the previous embodiments continue to apply as well and will only be repeated selectively.

Different from the fourth embodiment, the resistive third element 70 of the fourth embodiment is now embodied as a resistive auxiliary element 76 adapted to be used for measuring a temperature of the structure 28. In order to obtain a sufficient length of the auxiliary element 76, a section of the auxiliary element 76, here the section that lies closest to the center 46 of the structure 28, extends as a meander with a plurality of turns, preferably more than 5 or 10, and in particular more than 15. In this embodiment the temperature sensing element, i.e. the resistive auxiliary element 76, measures directly the temperature of the structure 28. While a long-term instability of the material needs to be looked at, the possibility to obtain real-time control of the structure 28 is very beneficial.

Fig. 17 shows a fifteenth embodiment of a device for emission of thermal radiation. All the explanations made in the context of the seventh and fourteenth embodiments apply as well and will not be repeated. Also, all reference numerals introduced in the context of the previous embodiments continue to apply as well and will only be repeated selectively.

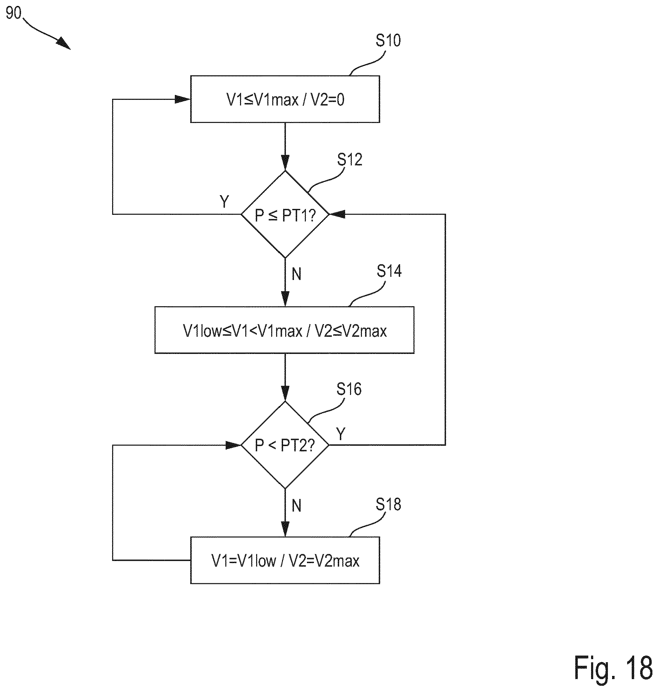

Fig. 18 shows an embodiment of a method 90 of operating a device 12 with a resistive first element 34 with electrical first contact sections 36 and a resistive second element 38 with electrical second contact sections 40. In particular, the device 12 can be a device 12 as described above. The device 12 is operated depending on a desired power P of emission of thermal radiation.

If, step S12, the desired power P is less than or equal to a first predefined threshold PT1 of the desired power P, up to a first predefined maximum voltage, path Y, a first voltage V1 is applied, step S10, to the first contact sections 36, the first voltage V1 selected to achieve the desired power P, and no second voltage V2 is applied to the second contact sections 40, wherein the first predefined threshold PT1 is defined by a first maximum power that is provided at the first maximum voltage V1max of the first element 34. The first voltage V1 being variable.

If, a combination of steps S12 and S16, the desired power P is greater than the first predefined threshold PT1, path N of step S12, and less than a second predefined threshold PT2 of the desired power P, the first voltage V1 is applied to the first contact sections 36 and the second voltage V2 is applied to the second contact sections 40. At this stage, the first voltage V1 decreases with an increasing desired power P from the first maximum voltage V1max down to a target low first voltage V1low greater than zero, and the second voltage V2 increases with the increasing desired power P up to a second predefined maximum voltage V2max. The first voltage V1 and the second voltage V2 are selected to achieve the desired power P.

The second predefined threshold PT2 is preferably defined by a predefined maximum temperature of the first and second elements 34, 38 that is achieved when the target low first voltage V1low is applied to the first contact sections 36 and the second maximum voltage V2max is applied to the second contact sections 40.

If, step S16, the desired power P is at or above the second predefined threshold PT2, path N of step S16, the target low first voltage V1low is applied to the first contact sections 36 and the second maximum voltage V2max is applied to the second contact sections 40.

If, a combination of steps S12 and S16 not according to the invention, the desired power P is greater than the first predefined threshold PT1, path N of step S12, and less than or equal to a second predefined threshold PT2 of the desired power P, path Y of step S16, up to a second predefined maximum voltage V2max, a second voltage V2 is applied, step S14, to the second contact sections 40, the second voltage V2 selected to achieve the desired power P, and no first voltage V1 is applied to the first contact sections 36, wherein the second predefined threshold PT2 is defined by a second maximum power that is provided at a second maximum voltage of the second element 38. The second voltage V2 being variable.

## Claims

1. A method (90) of operating a device (12) with a resistive first element (34) with electrical first contact sections (36) and a resistive second element (38) with electrical second contact sections (40) depending on a desired power (P) of emission of thermal radiation, the method (90) comprising the steps of:
- if (S12) the desired power (P) is less than or equal to a first predefined threshold (PT1) of the desired power (P), applying (S10), up to a first predefined maximum voltage, a first voltage (V1) to the first contact sections (36), the first voltage (V1) selected to achieve the desired power (P), and applying no second voltage (V2) to the second contact sections (40), wherein the first predefined threshold (PT1) is defined by a first maximum power that is provided at the first maximum voltage (V1max) of the first element (34),
- if (S12, S16) the desired power (P) is greater than the first predefined threshold (PT1) and less than a second predefined threshold (PT2) of the desired power (P), applying (S14) the first voltage (V1) to the first contact sections (36) and the second voltage (V2) to the second contact sections (40), wherein the first voltage (V1) decreases with an increasing desired power (P) from the first maximum voltage (V1max) down to a target low first voltage (V1low) greater than zero and the second voltage (V2) increases with the increasing desired power (P) up to a second predefined maximum voltage (V2max), wherein the first voltage (V1) and the second voltage (V2) are selected to achieve the desired power (P), and
- if (S16) the desired power (P) is at or above the second predefined threshold (PT2), applying (S18) the target low first voltage (V1low) to the first contact sections (36) and the second maximum voltage (V2max) to the second contact sections (40).

2. A device (12) for emission of thermal radiation, the device (12) configured to operate according to the method of claim 1 and comprising:
- a substrate (24),
- a membrane (26), wherein the substrate (24) provides a frame for the membrane (26),
- a resistive structure (28) on the membrane (26), the structure arranged at least substantially within a plane (XY) and comprising the resistive first element (34) with electrical first contact sections (36) and the resistive second element (38) with the electrical second contact sections (40), and
- an emitter (32) of the thermal radiation arranged over the structure (28),
wherein at least one of the first contact sections (36) is arranged on a first side (42) of the structure (28) and at least one of the second contact sections (40) is arranged on a second side (44) of the structure (28) and wherein the first side (42) is different from the second side (44).

3. The device (12) of claim 2, wherein the first side (42) and the second side (44) are at an angle of greater than 45° and less than 315° to each other relative to a center (46) of the structure (28).

4. The device (12) of claim 3, wherein the at least one of the first contact sections (36) and the at least one of the second contact sections (40) are at an angle of greater than 45° and less than 315° to each other relative to a center (46) of the structure (28).

5. The device (12) of claim 2, wherein the at least one of the first contact sections (36) and the at least one of the second contact sections (40) are arranged in opposition to each other across a center (46) of the structure (28).

6. The device (12) of any of claims 2 to 5, wherein, in the plane (XY), a second outer periphery (48) of the second element (38) has an opening (50) adapted to provide a passage for the first element (34) from the electrical first contact sections (36) arranged outside the second outer periphery (48) to a second inner portion (52) of the second element (38).

7. The device (12) of any of claims 2 to 6, wherein, in the plane (XY), a second inner periphery (54) of the second element (38) is facing a first outer periphery (56) of the first element (34).

8. The device (12) of claim 7, wherein, over a major portion of the first outer periphery (56), the first outer periphery (56) has a gap of a constant width towards the second inner periphery (54).

9. The device (12) of any of claims 2 to 8, wherein the second element (38) has a horseshoe-like shape with an opening (50) and the first element (34) passes through the opening (50).

10. The device (12) of any of claims 2 to 9, wherein, in the plane (XY), a first surface of the first element (34) is less than a second surface of the second element (38).

11. The device (12) of any of claims 2 to 10, wherein the second element (38) comprises a second conductive track (64) extending from the electrical second contact sections (40), and wherein the second conductive track (64) comprises a second inner section (66) and a second outer section (68).

12. The device (12) of claim 11, wherein the second inner section (66) has a shape of an arc with an arc angle between 270° and 345° and/or wherein the second outer section (68) comprises two further arcs, each further arc with a further arc angle between 105° and 175°.

13. The device (12) of any of claims 2 to 12, wherein the structure (28) further comprises a resistive third element (70) that is arranged in the plane (XY) and within a first inner periphery (72) of the first element (34).

14. The device (12) of any of claims 2 to 13, wherein the structure (28) further comprises a resistive auxiliary element (76) adapted to be used for measuring a temperature of the structure (28) and/or of the substrate (24).

15. A system (10) for optical gas analysis, the system (10) comprising:
- a device (12) as claimed in any of claims 2 to 14, the device (12) adapted to emit a first light (14) through a gas (16) to be analyzed;
- at least one light sensor (18); and
- an analyzer (20), wherein the analyzer (20) is adapted to determine at least one gas concentration of at least one component of the gas (16) based on a second light (22) detected by the at least one light sensor (18), wherein the passing through the gas (16) changes the first light (14) into the second light (22).

## Patentansprüche

1. Verfahren (90) zum Betreiben einer Vorrichtung (12) mit einem resistiven ersten Element (34) mit elektrischen ersten Kontaktabschnitten (36) und einem resistiven zweiten Element (38) mit elektrischen zweiten Kontaktabschnitten (40) in Abhängigkeit von einer gewünschten Leistung (P) einer Emission von Wärmestrahlung, wobei das Verfahren (90) die folgenden Schritte aufweist:
- wenn (S12) die gewünschte Leistung (P) kleiner als oder gleich einem ersten vordefinierten Schwellenwert (PT1) der gewünschten Leistung (P) ist, Anlegen (S10) einer ersten Spannung (V1) an die ersten Kontaktabschnitte (36) bis zu einer ersten vordefinierten Maximalspannung, wobei die erste Spannung (V1) ausgewählt ist, um die gewünschte Leistung (P) zu erreichen, und Anlegen keiner zweiten Spannung (V2) an die zweiten Kontaktabschnitte (40), wobei der erste vordefinierte Schwellenwert (PT1) durch eine erste Maximalleistung definiert ist, die bei der ersten Maximalspannung (V1max) des ersten Elements (34) bereitgestellt wird,
- wenn (S12, S16) die gewünschte Leistung (P) größer als der erste vordefinierte Schwellenwert (PT1) und kleiner als ein zweiter vordefinierter Schwellenwert (PT2) der gewünschten Leistung (P) ist, Anlegen (S14) der ersten Spannung (V1) an die ersten Kontaktabschnitte (36) und der zweiten Spannung (V2) an die zweiten Kontaktabschnitte (40), wobei die erste Spannung (V1) mit einer zunehmenden gewünschten Leistung (P) von der ersten Maximalspannung (V1max) auf eine angestrebte niedrige erste Spannung (V1low) größer als null abnimmt und die zweite Spannung (V2) mit der zunehmenden gewünschten Leistung (P) bis zu einer zweiten vordefinierten Maximalspannung (V2max) zunimmt, wobei die erste Spannung (V1) und die zweite Spannung (V2) ausgewählt sind, um die gewünschte Leistung (P) zu erreichen, und
- wenn (S16) die gewünschte Leistung (P) gleich oder größer als der zweite vordefinierte Schwellenwert (PT2) ist, Anlegen (S18) der angestrebten niedrigen ersten Spannung (V1low) an die ersten Kontaktabschnitte (36) und der zweiten Maximalspannung (V2max) an die zweiten Kontaktabschnitte (40).

2. Vorrichtung (12) zur Emission von Wärmestrahlung, wobei die Vorrichtung (12) dazu konfiguriert ist, gemäß dem Verfahren nach Anspruch 1 zu arbeiten, und aufweisend:
- ein Substrat (24),
- eine Membran (26), wobei das Substrat (24) einen Rahmen für die Membran (26) bildet,
- eine resistive Struktur (28) auf der Membran (26), wobei die Struktur zumindest im Wesentlichen innerhalb einer Ebene (XY) angeordnet ist und das resistive erste Element (34) mit elektrischen ersten Kontaktabschnitten (36) und das resistive zweite Element (38) mit den elektrischen zweiten Kontaktabschnitten (40) aufweist, und
- einen Emitter (32) der Wärmestrahlung, der über der Struktur (28) angeordnet ist,
wobei mindestens einer der ersten Kontaktabschnitte (36) auf einer ersten Seite (42) der Struktur (28) angeordnet ist und mindestens einer der zweiten Kontaktabschnitte (40) auf einer zweiten Seite (44) der Struktur (28) angeordnet ist und wobei die erste Seite (42) verschieden von der zweiten Seite (44) ist.

3. Vorrichtung (12) nach Anspruch 2, wobei die erste Seite (42) und die zweite Seite (44) in einem Winkel von größer als 45° und kleiner als 315° zueinander bezogen auf ein Zentrum (46) der Struktur (28) angeordnet sind.

4. Vorrichtung (12) nach Anspruch 3, wobei der mindestens eine der ersten Kontaktabschnitte (36) und der mindestens eine der zweiten Kontaktabschnitte (40) in einem Winkel von größer als 45° und kleiner als 315° zueinander bezogen auf ein Zentrum (46) der Struktur (28) angeordnet sind.

5. Vorrichtung (12) nach Anspruch 2, wobei der mindestens eine der ersten Kontaktabschnitte (36) und der mindestens eine der zweiten Kontaktabschnitte (40) einander gegenüberliegend über ein Zentrum (46) der Struktur (28) hinweg angeordnet sind.

6. Vorrichtung (12) nach einem der Ansprüche 2 bis 5, wobei in der Ebene (XY) ein zweiter äußerer Umfang (48) des zweiten Elements (38) eine Öffnung (50) aufweist, die dazu ausgebildet ist, einen Durchgang für das erste Element (34) von den elektrischen ersten Kontaktabschnitten (36), die außerhalb des zweiten äußeren Umfangs (48) angeordnet sind, zu einem zweiten inneren Teil (52) des zweiten Elements (38) bereitzustellen.

7. Vorrichtung (12) nach einem der Ansprüche 2 bis 6, wobei in der Ebene (XY) ein zweiter innerer Umfang (54) des zweiten Elements (38) einem ersten äußeren Umfang (56) des ersten Elements (34) zugewandt ist.

8. Vorrichtung (12) nach Anspruch 7, wobei über einen überwiegenden Teil des ersten äußeren Umfangs (56) der erste äußere Umfang (56) einen Spalt konstanter Breite zu dem zweiten inneren Umfang (54) hin aufweist.

9. Vorrichtung (12) nach einem der Ansprüche 2 bis 8, wobei das zweite Element (38) eine hufeisenähnliche Form mit einer Öffnung (50) aufweist und das erste Element (34) durch die Öffnung (50) verläuft.

10. Vorrichtung (12) nach einem der Ansprüche 2 bis 9, wobei in der Ebene (XY) eine erste Fläche des ersten Elements (34) kleiner als eine zweite Fläche des zweiten Elements (38) ist.

11. Vorrichtung (12) nach einem der Ansprüche 2 bis 10, wobei das zweite Element (38) eine zweite leitfähige Bahn (64) aufweist, die sich von den elektrischen zweiten Kontaktabschnitten (40) erstreckt, und wobei die zweite leitfähige Bahn (64) einen zweiten inneren Abschnitt (66) und einen zweiten äußeren Abschnitt (68) aufweist.

12. Vorrichtung (12) nach Anspruch 11, wobei der zweite innere Abschnitt (66) die Form eines Bogens mit einem Bogenwinkel zwischen 270° und 345° hat und/oder wobei der zweite äußere Abschnitt (68) zwei weitere Bögen aufweist, wobei jeder weitere Bogen einen weiteren Bogenwinkel zwischen 105° und 175° aufweist.

13. Vorrichtung (12) nach einem der Ansprüche 2 bis 12, wobei die Struktur (28) ferner ein resistives drittes Element (70) aufweist, das in der Ebene (XY) und innerhalb eines ersten inneren Umfangs (72) des ersten Elements (34) angeordnet ist.

14. Vorrichtung (12) nach einem der Ansprüche 2 bis 13, wobei die Struktur (28) ferner ein resistives Hilfselement (76) aufweist, das dazu ausgebildet ist, zum Messen einer Temperatur der Struktur (28) und/oder des Substrats (24) verwendet zu werden.

15. System (10) zur optischen Gasanalyse, wobei das System (10) aufweist:
- eine Vorrichtung (12) nach einem der Ansprüche 2 bis 14, wobei die Vorrichtung (12) dazu ausgebildet ist, ein erstes Licht (14) durch ein zu analysierendes Gas (16) zu emittieren;
- mindestens einen Lichtsensor (18); und
- einen Analysator (20), wobei der Analysator (20) dazu ausgebildet ist, mindestens eine Gaskonzentration mindestens einer Komponente des Gases (16) basierend auf einem zweiten Licht (22), das von dem mindestens einen Lichtsensor (18) erfasst wird, zu bestimmen, wobei das Durchlaufen des Gases (16) das erste Licht (14) in das zweite Licht (22) ändert.

## Revendications

1. Procédé (90) de fonctionnement d'un dispositif (12) avec un premier élément résistif (34) avec des premières sections de contact électriques (36) et un deuxième élément résistif (38) avec des deuxièmes sections de contact électriques (40) en fonction d'une puissance souhaitée (P) d'émission de rayonnement thermique, le procédé (90) comprenant les étapes consistant à :
- si (S12) la puissance souhaitée (P) est inférieure ou égale à un premier seuil prédéfini (PT1) de la puissance souhaitée (P), appliquer (S10), jusqu'à une première tension maximale prédéfinie, une première tension (V1) aux premières sections de contact (36), la première tension (V1) étant sélectionnée pour atteindre la puissance souhaitée (P), et n'appliquer aucune deuxième tension (V2) aux deuxièmes sections de contact (40), dans lequel le premier seuil prédéfini (PT1) est défini par une première puissance maximale qui est fournie à la première tension maximale (V1max) du premier élément (34),
- si (S12, S16) la puissance souhaitée (P) est supérieure au premier seuil prédéfini (PT1) et inférieure à un deuxième seuil prédéfini (PT2) de la puissance souhaitée (P), appliquer (S14) la première tension (V1) aux premières sections de contact (36) et la deuxième tension (V2) aux deuxièmes sections de contact (40), dans lequel la première tension (V1) diminue avec une puissance souhaitée croissante (P) depuis la première tension maximale (V1max) jusqu'à une première tension basse cible (V1low) supérieure à zéro et la deuxième tension (V2) augmente avec la puissance souhaitée croissante (P) jusqu'à une deuxième tension maximale prédéfinie (V2max), dans lequel la première tension (V1) et la deuxième tension (V2) sont sélectionnées pour atteindre la puissance souhaitée (P), et
- si (S16) la puissance souhaitée (P) est égale ou supérieure au deuxième seuil prédéfini (PT2), appliquer (S18) la première tension basse cible (V1low) aux premières sections de contact (36) et la deuxième tension maximale (V2max) aux deuxièmes sections de contact (40).

2. Dispositif (12) pour l'émission de rayonnement thermique, le dispositif (12) étant configuré pour fonctionner selon le procédé de la revendication 1 et comprenant :
- un substrat (24),
- une membrane (26), dans lequel le substrat (24) fournit un cadre pour la membrane (26),
- une structure résistive (28) sur la membrane (26), la structure étant agencée au moins sensiblement dans un plan (XY) et comprenant le premier élément résistif (34) avec des premières sections de contact électriques (36) et le deuxième élément résistif (38) avec les deuxièmes sections de contact électriques (40), et
- un émetteur (32) du rayonnement thermique agencé au-dessus de la structure (28),
dans lequel au moins une des premières sections de contact (36) est agencée sur un premier côté (42) de la structure (28) et au moins une des deuxièmes sections de contact (40) est agencée sur un deuxième côté (44) de la structure (28) et dans lequel le premier côté (42) est différent du deuxième côté (44).

3. Dispositif (12) selon la revendication 2, dans lequel le premier côté (42) et le deuxième côté (44) sont à un angle supérieur à 45° et inférieur à 315° l'un par rapport à l'autre relativement à un centre (46) de la structure (28).

4. Dispositif (12) selon la revendication 3, dans lequel l'au moins une des premières sections de contact (36) et l'au moins une des deuxièmes sections de contact (40) sont à un angle supérieur à 45° et inférieur à 315° l'une par rapport à l'autre relativement à un centre (46) de la structure (28).

5. Dispositif (12) selon la revendication 2, dans lequel l'au moins une des premières sections de contact (36) et l'au moins une des deuxièmes sections de contact (40) sont agencées à l'opposé l'une de l'autre de part et d'autre d'un centre (46) de la structure (28).

6. Dispositif (12) selon l'une quelconque des revendications 2 à 5, dans lequel, dans le plan (XY), une deuxième périphérie extérieure (48) du deuxième élément (38) présente une ouverture (50) conçue pour fournir un passage pour le premier élément (34) depuis les premières sections de contact électriques (36) agencées à l'extérieur de la deuxième périphérie extérieure (48) jusqu'à une deuxième partie intérieure (52) du deuxième élément (38).

7. Dispositif (12) selon l'une quelconque des revendications 2 à 6, dans lequel, dans le plan (XY), une deuxième périphérie intérieure (54) du deuxième élément (38) fait face à une première périphérie extérieure (56) du premier élément (34).

8. Dispositif (12) selon la revendication 7, dans lequel, sur une majeure partie de la première périphérie extérieure (56), la première périphérie extérieure (56) présente un espace de largeur constante vers la deuxième périphérie intérieure (54).

9. Dispositif (12) selon l'une quelconque des revendications 2 à 8, dans lequel le deuxième élément (38) a une forme de type fer à cheval avec une ouverture (50) et le premier élément (34) passe à travers l'ouverture (50).

10. Dispositif (12) selon l'une quelconque des revendications 2 à 9, dans lequel, dans le plan (XY), une première surface du premier élément (34) est inférieure à une deuxième surface du deuxième élément (38).

11. Dispositif (12) selon l'une quelconque des revendications 2 à 10, dans lequel le deuxième élément (38) comprend une deuxième piste conductrice (64) s'étendant depuis les deuxièmes sections de contact électriques (40), et dans lequel la deuxième piste conductrice (64) comprend une deuxième section intérieure (66) et une deuxième section extérieure (68).

12. Dispositif (12) selon la revendication 11, dans lequel la deuxième section intérieure (66) a la forme d'un arc avec un angle d'arc compris entre 270° et 345° et/ou dans lequel la deuxième section extérieure (68) comprend deux autres arcs, chaque autre arc présentant un autre angle d'arc compris entre 105° et 175°.

13. Dispositif (12) selon l'une quelconque des revendications 2 à 12, dans lequel la structure (28) comprend en outre un troisième élément résistif (70) qui est agencé dans le plan (XY) et à l'intérieur d'une première périphérie intérieure (72) du premier élément (34).

14. Dispositif (12) selon l'une quelconque des revendications 2 à 13, dans lequel la structure (28) comprend en outre un élément auxiliaire résistif (76) conçu pour être utilisé pour mesurer une température de la structure (28) et/ou du substrat (24).

15. Système (10) pour l'analyse optique de gaz, le système (10) comprenant :
- un dispositif (12) selon l'une quelconque des revendications 2 à 14, le dispositif (12) étant conçu pour émettre une première lumière (14) à travers un gaz (16) à analyser ;
- au moins un capteur de lumière (18) ; et
- un analyseur (20), dans lequel l'analyseur (20) est conçu pour déterminer au moins une concentration de gaz d'au moins un composant du gaz (16) sur la base d'une deuxième lumière (22) détectée par l'au moins un capteur de lumière (18), dans lequel le passage à travers le gaz (16) transforme la première lumière (14) en la deuxième lumière (22).
